# EUROPÄISCHE PATENTSCHRIFT

(11) **EP 0 756 244 B1**
(45) Veröffentlichungstag und Bekanntmachung des Hinweises auf die Patenterteilung: **12.03.2003**
(21) Anmeldenummer: 96112037.5
(22) Anmeldetag: 25.07.1996
(51) Int. Cl.: G06K 19/077

(54) **Schaltungseinheit und Verfahren zur Herstellung einer Schaltungseinheit**
Electronic unit and method of producing that unit
Unité électronique et procédé de fabrication de cette unité

(30) Priorität: 26.07.1995 DE 19527359
(43) Veröffentlichungstag der Anmeldung: 29.01.1997
(73) Patentinhaber: Giesecke & Devrient GmbH, 81677 München (DE)
(72) Erfinder: Haghiri-Tehrani, Yahya, 80797 München (DE); Welling, Ando, Dr., 80803 München (DE)
(74) Vertreter: Klunker . Schmitt-Nilson . Hirsch

(56) Entgegenhaltungen:
- WO-A-96/05572
- DE-A- 4 416 697
- DE-C- 4 428 732
- DE-U- 9 217 070
- FR-A- 2 621 147
- US-A- 4 999 742
- PATENT ABSTRACTS OF JAPAN vol. 95, no. 3, 28. April 1995 & JP 06 336096 A (OMRON CORP), 6. Dezember 1994

## Beschreibung

Die Erfindung betrifft eine Schaltungseinheit, die mindestens ein isolierendes Trägersubstrat, auf dem sich eine leitende Spule befindet, und einen integrierten Schaltkreis umfaßt, dessen Anschlußpunkte leitend mit den Spulenenden verbunden sind. Die Erfindung betrifft ferner ein Verfahren zur Herstellung einer solchen Schaltungseinheit.

Schaltungseinheiten der obengenannten Art sind bereits aus dem Stand der Technik bekannt und werden beispielsweise als kompaktes elektronisches Modul ausgebildet, das in eine Chipkarte für den berührungslosen Datenaustausch mit einem Terminal eingesetzt wird. Aus der US-PS 4,999,742 ist z.B. eine Schaltungseinheit in Form eines elektronischen Moduls mit einem isolierenden Trägersubstrat bekannt, auf das eine ringförmige gewickelte Spule aufgeklebt ist. Die Spulenenden sind in den Aufnahmeraum geführt, der durch die ringförmige Spule entsteht, und dort leitend mit den Anschlußpunkten eines integrierten Schaltkreises verbunden. Der Aufnahmeraum für den integrierten Schaltkreis und die Spulenenden ist zum Schutz dieser empfindlichen Bestandteile vor mechanischen Belastungen mit einer Gußmasse vergossen.

Das aus der US-PS 4,999,742 bekannte elektronische Modul weist einen kompakten Aufbau auf, jedoch muß die Spule in einem separaten Verfahrensschritt gewickelt und in einem weiteren Verfahrensschritt auf das isolierende Trägersubstrat aufgeklebt werden.

Aus der noch nicht veröffentlichten deutschen Patentanmeldung P 4416 697.4 ist hingegen eine Schaltungseinheit in Form einer Chipkarte bekannt, auf deren einer Kartenschicht des mehrschichtigen Kartenkörpers eine Spule aus einem leitenden Lack aufgedruckt ist, deren Spulenenden leitend mit den Anschlußpunkten eines integrierten Schaltkreises verbunden sind.

Der Aufbau der aus der Patentanmeldung 44 16 697.4 bekannten Schaltungseinheit hat den Vorteil, daß die Spule direkt auf eine Kartenschicht aufgedruckt wird und somit der Verfahrensschritt, eine separat gefertigte Spule auf ein isolierendes Trägersubstrat aufzubringen, entfällt. Für einige Anwendungen der Schaltungseinheit ist es jedoch wünschenswert, daß die Spule eine höhere Anzahl von Spulenwindungen aufweist, als sie sich mit dem oben erläuterten Aufbau realisieren läßt. Weiterhin kann es wünschenswert sein, die Schaltungseinheit mit einer Hochprägung zu versehen. Dabei muß jedoch sichergestellt werden, daß die aufgedruckten Spulenwindungen, die in der Regel als eine sehr dünne Schicht ausgebildet sind, nicht unterbrochen werden. Ebenso sollte das Herstellungsverfahren der Schaltungseinheit im Hinblick auf eine preisgünstige Massenfertigung weiter optimiert werden.

Aus JP 6336096 A1 ist eine Chipkarte bekannt, die aus zwei Trägersubstraten aufgebaut ist. Die Trägersubstrate weisen jeweils auf einer ihrer Oberflächen eine Spulenlage auf. Um die Chipkarte zu bilden, werden die Trägersubstrate mit ihren die Spulenlagen aufweisenden Oberflächen verklebt. Zum Aufbau einer aus maximal zwei Spulenlagen bestehenden Spule wird dazu an Kontaktstellen der Spulenlagen kein Kleber aufgetragen. An den anderen Stellen wirkt der Kleber als Isolierung zwischen den beiden Spulenlagen.

Aus DE 92 17 070 U1 ist eine Leiterplattenantenne bekannt, die aus mehreren flachen Spulen aufgebaut ist Die flachen Spulen werden auf jeweils ein Trägersubstrat, d. h. eine Leiterplattenschicht, aufgebracht und sind über Durchkontaktierungen, die von zusätzlichem, elektrisch leitenden Material gebildet werden, miteinander zu der Leiterplattenantenne verbunden. Die sich dabei ergebenden Anschlüsse der Leiterplattenantenne liegen auf verschiedenen Seiten der Leiterplatten.

Aus FR 2 621 147 A1 ist eine Chipkarte mit einer Antenne bekannt. Bei der bekannte Chipkarte wird die Antenne jedoch auf dem Halbleitermaterial des Chips der Chipkarte selbst erzeugt.

Aus der nicht vorveröffentlichten WO 96/05572 A1 ist eine mehrlagige Chipkartenspule für kontaktfreie Chipkarten bekannt. Dabei werden Antennenlagen auf eine Folie aufgedruckt und durch Falten der Folie wird erreicht, daß die Antennenlagen übereinander liegen. Mittels Löchern in der Folie werden die Antennenlagen mittels zusätzlichem, elektrisch leitenden Material miteinander zu einer Spule verbunden.

Es ist deshalb Aufgabe der Erfindung, die obengenannte Schaltungseinheit weiter zu verbessern und dabei insbesondere deren Einsatzmöglichkeiten zu erweitern. Es ist ferner Aufgabe der Erfindung, ein Verfahren zur Herstellung einer solchen Schaltungseinheit vorzuschlagen.

Die Aufgabe wird durch die nebengeordneten Ansprüche gelöst.

Ein Vorteil der Erfindung ist darin zu sehen, daß eine höhere Windungszahl realisiert werden kann als auf dem aus der deutschen Patentanmeldung 4416197.4 bekannten Aufbau. Dabei kann die Spule weiterhin direkt auf das Trägersubstrat der Schaltungseinheit aufgebracht werden, so daß ein zusätzlicher Verfahrensschritt für das Aufbringen einer separat gefertigten Spule nicht erforderlich ist. Dies wird dadurch ermöglicht, daß auf dem isolierenden Trägersubstrat im Wechsel Spulenlagen und isolierende Schichten aufgebracht sind, wobei die einzelnen Spulenlagen über Durchkontaktierungen leitend miteinander verbunden sind, so daß eine Spule entsteht. Vorzugsweise werden die Spulenlagen und die isolierenden Schichten aufgedruckt. Alternativ ist es auch möglich, daß die isolierenden Schichten aus dünnen Isolierfolien bestehen, auf denen die Spulenlagen ein- oder beidseitig aufgedruckt sind. Die Durchkontaktierung durch die isolierenden Schichten kann im einfachsten Fall durch das Vorsehen von Fenstern oder Löchern in den isolierenden Schichten erfolgen, durch die hindurch das leitfähige Material der Spulenlagen beim Aufdrucken der Spulenlagen oder beim Zusammenlaminieren der Schichten dringt. Ebenso kann für die Durchkontaktierung auch zusätzliches leitfähiges Material aufgebracht werden oder es können zusätzlich leitfähige Elemente vorgesehen werden.

Ein weiterer Vorteil der Erfindung ist darin zu sehen, daß die Schaltungseinheit besonders einfach im Mehrnutzenverfahren gefertigt werden kann, da bei der Aufbringung der Spulenlagen und je nach Ausführungsform auch der isolierenden Schichten auf die Drucktechnik zurückgegriffen werden kann, bei der die Mehrnutzenfertigung gang und gäbe ist.

Darüber hinaus hat die Erfindung den Vorteil, daß die Spulenenden auf besonders einfache Art und Weise an die unterschiedlichen Möglichkeiten der Herstellung der leitenden Verbindung zwischen den Spulenenden und den Anschlußpunkten des integrierten Schaltkreises angepaßt werden können.

Weiterhin ist es vorteilhaft, daß die Erfindung eine Hochprägung der Schaltungseinheit uneingeschränkt zuläßt, ohne daß die Gefahr einer Unterbrechung einer oder mehrerer Spulenwindungen besteht. Hierzu werden die Spulenwindungen außerhalb des Hochprägebereiches der Schaltungseinheit geführt oder zwischen den einzelnen Hochprägezeilen, wobei die Breite der Spulenwindungen zum Ausgleich von Fertigungstoleranzen jeweils größer sein kann als der Zeilenabstand oder die Spulenwindungen verlaufen im Bereich der hochgeprägten Zeichen, sind jedoch breiter als die Zeichengröße.

Ausführungsbeispiele und weitere Vorteile der Erfindung sind in Zusammenhang mit den nachstehenden Figuren erläutert, darin zeigen:
- Fig. 1: eine Schaltungeinheit in Aufsicht,
- Fig. 2: eine Schaltungseinheit in perspektivischer Sicht,
- Fig. 3: einen Querschnitt entlang der Linie A - A der Fig. 2,
- Fig. 4, 5: Ausführungsbeispiele für die Kontaktierung einer Spule an einen integrierten Schaltkreis bzw. an ein Modul,
- Fig. 6: Ausführungsbeispiele für die Durchkontaktierung zur Herstellung einer leitenden Verbindung zwischen gegenüberliegenden Spulenlagen im Querschnitt,
- Fig. 7: (gestrichen)
- Fig. 8: eine Schaltungseinheit mit eingezeichneten Hochprägefeldern in Aufsicht,
- Fig. 9, 10: Ausführungsbeispiele für die Ausbildung und Anordnung von Spulenwindungen als vergrößerten Ausschnitt in Aufsicht.

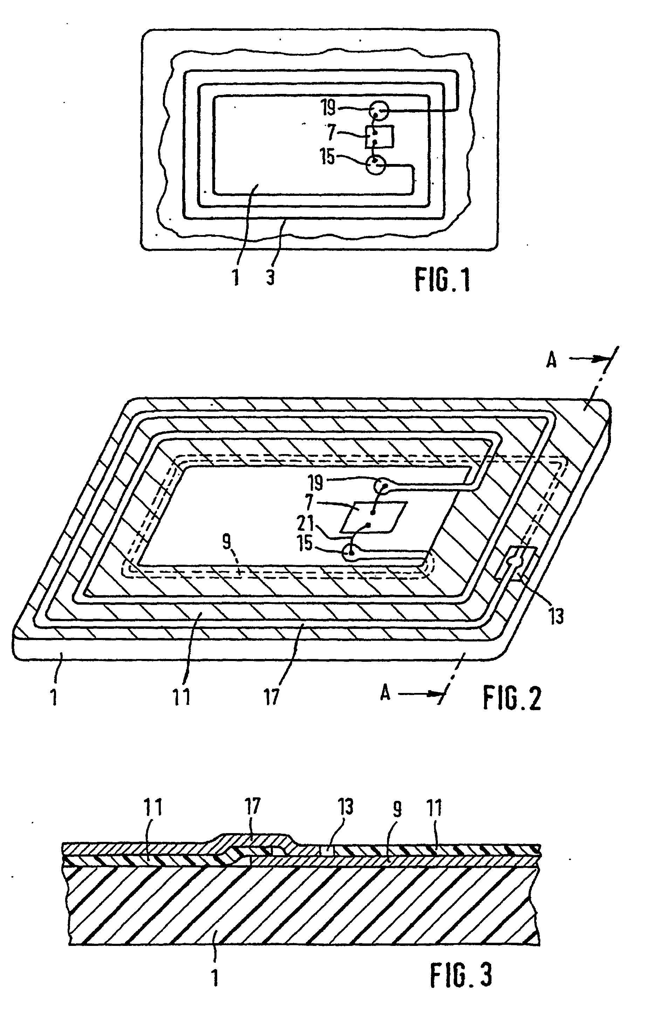

Fig. 1 zeigt systematisch eine Schaltungseinheit in Form einer Chipkarte für den berührungslosen Datenaustausch in Aufsicht. Die Abmessungen solcher Chipkarten sind mit den Abmessungen der Chipkarten für den berührenden Datenaustausch identisch, die in der ISO-Norm 7810 festgelegt sind. Die Schaltungseinheit enthält ein isolierendes Trägersubstrat in Form einer Kartenschicht, auf dem die Spule 3 liegt, deren Spulenenden 15 und 19 leitend mit den Anschlußpunkten eines integrierten Schaltkreises 7 verbunden sind. Der integrierte Schaltkreis kann auch zu einem Modul vergossen sein, das zur leichteren Kontaktierung des integrierten Schaltkreises 7 Kontaktflächen aufweist, die leitend mit den Anschlußpunkten des integrierten Schaltkreises 7 verbunden sind. Die Spulenwindungen der Spule 3 laufen am äußeren Rand der Kartenschicht entlang, damit zugunsten einer hohen Energieeinkopplung eine großflächige Spule entsteht.

Fig. 2 zeigt nicht maßstabsgetreu und in perspektivischer Sicht eine erfindungsgemäße Schaltungseinheit, die wie folgt beschrieben hergestellt wird. Auf das isolierende Trägersubstrat 1, das z.B. in Form einer Kartenschicht vorliegt (siehe Fig. 1), wird zunächst eine erste Spulenlage 9, die in der Fig. 2 strichliniert gezeigt ist und mehrere Spulenwindungen enthalten kann, aufgebracht (die gezeigte Spulenlage 9 enthält, um die Zeichnung übersichtlicher zu halten, nur eine Spulenwindung). Vorzugsweise wird die Spulenlage 9 mit einem leitenden Lack aufgedruckt, es ist aber auch möglich, die Spulenlage unter Verwendung einer entsprechenen Maske aufzusprühen, bzw. aus einer leitenden Beschichtung, die sich auf dem Trägersubstrat befindet, auszuätzen. Andere Herstellungstechniken sind denkbar.

Nach dem Aufbringen der Spulenlage 9 wird auf das isolierende Trägersubstrat 1 eine isolierende Schicht 11 aufgebracht, die in der Fig. 2 schraffiert gezeigt ist und die Spulenwindungen der Spulenlage 9 abdeckt. Die isolierende Schicht 11 weist ein Fenster 13 auf und wird auf die Spulenlage 9 derart aufgebracht, daß das Spulenende 15 der Spulenlage 9 nicht von ihr abgedeckt wird und daß zumindest das Spulenende der letzten Spulenwindung der Spulenlage 9 durch das Fenster 13 zugänglich ist. Vorzugsweise wird die isolierende Schicht 11 ebenfalls aufgedruckt, auch hier ist es aber möglich, sie unter Verwendung einer entsprechenden Maske aufzusprühen oder als isolierende Schicht 11 eine dünne Isolierfolie zu verwenden, etc.

In einem weiteren Verfahrensschritt wird auf die isolierende Schicht 11 eine weitere Spulenlage 17 aufgebracht, wozu die gleichen Techniken wie beim Aufbringen der Spulenlage 9 verwendet werden. Vorzugsweise wird auch die weitere Spulenlage 17 aufgedruckt. Die Spulenlage 17 wird durch das Fenster 13 in der isolierenden Schicht 11 leitend mit der Spulenlage 9 verbunden, so daß eine Spule 3, bestehend aus den Spulenlagen 9 und 17, entsteht. Die Herstellung einer leitenden Verbindung zwischen den Spulenlagen 9 und 17 kann dadurch erleichtert werden, daß man die Spulenenden, die leitend miteinander verbunden werden, gegenüber den Spulenwindungen verbreitert ausbildet, so wie es auch in der Fig. 2 gezeigt ist. Eine solche Verbreiterung ist drucktechnisch einfach realisierbar. Einzelheiten zur Verbindungstechnik werden weiter unten beschrieben.

Das Aufbringen weiterer isolierender Schichten und Spulenlagen in der erläuterten Art und Weise kann gegebenenfalls ein- oder mehrfach wiederholt werden, bis die aus den Spulenlagen zusammengesetzte Spule 3 der Schaltungseinheit die gewünschte Anzahl von Windungen aufweist. Hierbei ist darauf zu achten, daß das Spulenende 15 der zuerst aufgedruckten Spulenlage nicht abgedeckt wird und daß die Schaltungseinheit eine vorgegebene Höhe nicht überschreitet. Bei dem Aufdrucken der letzten Spulenlage kann das Spulenende 15 der zuerst aufgedruckten Spulenlage nochmals mit einem leitenden Lack überdruckt werden. Man erhält dann zwei frisch aufgedruckte Spulenenden 15 und 19, die sich besonders einfach leitend mit dem integrierten Schaltkreis verbinden lassen.

Das Spulenende 19 der zuletzt aufgebrachten Spulenlage, in der Fig. 2 also der Spulenlage 17, wird so aufgebracht, daß die Herstellung einer leitenden Verbindung von den Spulenenden 15 und 19 zu dem integrierten Schaltkreis 7 besonders einfach möglich ist. Bei dem in der Fig. 2 gezeigten Ausführungsbeispiel der Erfindung werden die Spulenlagen und die isolierenden Schichten auf das isolierende Trägersubstrat 1 in einer Art Rahmen aufgebracht. Die Spulenenden 15 und 19 werden in dem gezeigten Ausführungsbeispiel in das Rahmeninnere auf das isolierende Trägersubstrat 1 geführt. Hierbei wird eine Überlagerung von Spulenwindungen in einer Spulenlage dadurch vermieden, daß das innenliegende Spulenende der jeweiligen Spulenlage in den von dem Rahmen umschlossenen Teil geführt wird, wie es auch in der Fig. 2 gezeigt ist.

Durch eine geeignete Wahl der Spulenenden, die leitend mit dem integrierten Schaltkreis verbunden werden, kann eine Überlagerung von Spulenwindungen in einer Spulenlage immer vermieden werden. Soll beispielsweise das Spulenende 19 außerhalb des Rahmens liegen, so wird das innenliegende Spulenende der Spulenlage 17 mit der Spulenlage 9 verbunden und das außenliegende Spulenende der Spulenlage 17 nach außen geführt.

Alternativ ist es auch möglich, auf die letzte Spulenlage, deren freies Spulenende mit dem integrierten Schaltkreis verbunden wird, eine isolierende Schicht mit Fenster aufzubringen. Durch das Fenster kann dann das freie Spulenende über die Spulenlage in eine beliebige Richtung geführt werden, da es wegen der abdeckenden Schicht zu keinem Kurzschluß zwischen den Spulenwindungen kommen kann.

Gemäß dem Ausführungsbeispiel der Fig. 2 wird auf den nicht abgedeckten Teil des isolierenden Trägersubstrats 1 der integrierte Schaltkreis 7 aufgebracht, dessen Anschlußpunkte z.B. mittels Bonddrähtchen 21 leitend mit den Spulenenden 15 und 19 der entstandenen Spule verbunden werden. Hierbei kann die Herstellung der leitenden Verbindungen von dem integrierten Schaltkreis 7 zu den Spulenenden 15 und 19 dadurch vereinfacht werden, daß man die Spulenenden breiter als die einzelnen Spulenwindungen ausbildet. Dazu brauchen die Druckvorlagen bzw. bei aufgesprühten Spulenlagen die verwendeten Masken lediglich entsprechend angepaßt zu werden. Gesonderte Verfahrensschritte zur Erzeugung verbreiterter Spulenenden sind also nicht notwendig.

Fig. 3 zeigt zur Verdeutlichung der Schichtfolge einen Querschnitt entlang der Linie A - A der Fig. 2. Auf das isolierende Trägersubstrat 1 ist die Spulenlage 9 aufgebracht, die durch die isolierende Schicht 11 abgedeckt ist, die ein Fenster 13 enthält, durch das die weitere Spulenlage 17 leitend mit der Spulenlage 9 verbunden wird. Weitere isolierende Schichten und Spulenlagen können sich im Wechsel anschließen.

In einer Variante wird die Verbindung zwischen dem integrierten Schaltkreis 7 und den Spulenenden 15 und 19 nicht über Bonddrähtchen hergestellt, sondern durch direktes Aufsetzen des integrierten Schaltkreises 7 auf die Spulenenden 15 und 19. Hierzu kann der integrierte Schaltkreis 7 bzw. ein Modul 23, das den integrierten Schaltkreis 7 enthält, entweder auf die bereits aufgebrachten Spulenenden 15 und 19 aufgesetzt werden oder der Schaltkreis 7 bzw. das Modul 23 wird zuerst in das Trägersubstrat eingesetzt und anschließend mit den Spulenenden 15 und 19 überdruckt.

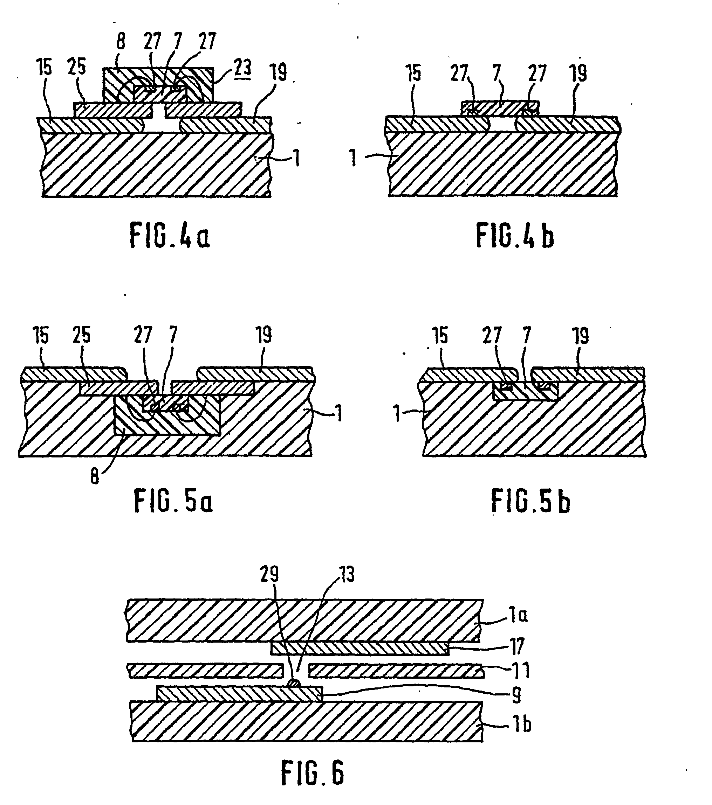

Fig. 4 zeigt Querschnitte zweier Ausführungsformen der erfindungsgemäßen Schaltungseinheit, bei denen zuerst die Spulenenden 15 und 19 auf das Trägersubstrat 1 aufgedruckt wurden und anschließend das Modul 23 bzw. der integrierte Schaltkreis 7 auf die Spulenenden 15 und 19 aufgesetzt wird. Das Aufsetzen des Moduls 23 bzw. des integrierten Schaltkreises 7 kann wahlweise unmittelbar nach dem Druckvorgang erfolgen oder erst nach einer kurzen Zeitspanne, in der der aufgedruckte Leitlack zumindest teilweise trocknet.

Fig. 4a zeigt das Trägersubstrat 1 mit aufgedruckten Spulenenden 15 und 19 und dem Modul 23. Das Modul 23 enthält den integrierten Schaltkreis 7, der von einer Vergußmasse 8 umhüllt ist und dessen Anschlußpunkte 27 mit Kontakten 25 des Moduls 23 über Bonddrähtchen leitend verbunden sind. Auf die Spulenenden 15 und 19 ist das Modul 23 so aufgesetzt, daß die Kontakte 25 des Moduls 23 die Spulenenden 15 bzw. 19 berühren. Die in Fig. 4a dargestellte Anordnung kann durch eine nicht figürlich dargestellte Deckfolie, die gegebenenfalls eine Aussparung für das Modul 23 enthält, abgedeckt werden. Bei dem in Fig. 4a dargestellten Ausführungsbeispiel ist das Modul 23 so auf die Spulenenden 15 und 19 aufgesetzt, daß die Vergußmasse 8 von den Spulenenden 15 und 19 wegweist. Es ist jedoch auch möglich, das Modul um 180° gedreht aufzusetzen. In diesem Fall ist im Trägersubstrat eine entsprechende Aussparung vorzusehen, die die Vergußmasse 8 teilweise aufnimmt. Diese Variante wird insbesondere dann eingesetzt, wenn eine niedrige Bauhöhe der Schaltungseinheit erzielt werden soll.

Fig. 4b zeigt wiederum ein Trägersubstrat 1 mit aufgedruckten Spulenenden 15 und 19. Auf die Spulenenden 15 und 19 ist der integrierte Schaltkreis 7 so aufgesetzt, daß die Anschlußpunkte 27 des integrierten Schaltkreises 7 die Spulenenden 15 bzw. 19 berühren. Wie beim Ausführungsbeispiel nach Fig. 4a kann auch der in Fig. 4b dargestellte Aufbau durch eine nicht dargestellte Abdeckfolie geschützt werden, die gegebenenfalls eine Aussparung für den integrierten Schaltkreis 7 enthalten kann.

Fig. 5 zeigt Querschnitte zweier Ausführungsformen der erfindungsgemäßen Schaltungseinheit, bei denen das Modul 23 bzw. der integrierte Schaltkreis 7 zur Kontaktierung mit den Spulenenden 15 und 19 überdruckt wird.

In Fig. 5a ist das Modul 23 so in das Trägersubstrat 1 eingepaßt, daß die Oberfläche des Moduls 23 bündig mit der Oberfläche des Trägersubstrats 1 abschließt. Die nach dem Einsetzen des Moduls 23 in das Trägersubstrat 1 aufgedruckten Spulenenden 15 und 19 erstrecken sich so weit über die Oberfläche des Moduls 23, daß sie die Kontakte 25 des Moduls 23 teilweise überdecken, so daß eine leitende Verbindung zwischen den Kontakten 25 und den Spulenenden 15 und 19 entsteht.

In Fig. 5b ist anstelle des Moduls 23 der integrierte Schaltkreis 7 so in das Trägersubstrat 1 eingesetzt, daß die Oberfläche des integrierten Schaltkreises 7 mit der Oberfläche des Trägersubstrats 1 bündig abschließt und die Anschlußpunkte 27 des integrierten Schaltkreises 7 nach oben weisen. Auf das Trägersubstrat 1 sind die Spulenenden 15 und 19 derart aufgedruckt, daß sie sich bis über die Anschlußpunkte 27 des integrierten Schaltkreises 7 erstrekken. Auf diese Weise wird jeweils eine leitende Verbindung zwischen den Anschlußpunkten 27 und den Spulenenden 15 und 19 hergestellt. Zur Einbettung des integrierten Schaltkreises 7 in das Trägersubstrat 1 kann entweder eine entsprechende Aussparung vorgesehen werden oder der Chip kann unter Anwendung von Hitze und Druck in das Trägersubstrat 1 eingepreßt werden.

Im folgenden werden einige Varianten für die Durchkontaktierung beschrieben, mit deren Hilfe elektrisch leitende Verbindungen zwischen zwei Spulenlagen bzw. zwischen einer Spulenlage und einem Anschlußpunkt 27 des integrierten Schaltkreises 7 oder einem Kontakt 25 des Moduls 23 durch die isolierende Schicht 11 hindurch, beispielsweise eine dünne Isolierfolie, hergestellt werden können.

Fig. 6 zeigt eine Ausführungsform der erfindungsgemäßen Schaltungseinheit im Querschnitt, bei der die Durchkontaktierung beim Zusammenlaminieren der einzelnen Schichten der Schaltungseinheit erfolgt. Dargestellt ist die Schichtenfolge der Schaltungseinheit vor dem Laminiervorgang.

Gemäß Fig. 6 werden ein Trägersubstrat 1a mit einer Spulenlage 17 und ein Trägersubstrat 1b mit einer Spulenlage 9 durch eine Isolierfolie 11 voneinander getrennt. In die Folie 11 ist durch Ausstanzen, Durchstechen oder mittels eines Laserstrahls ein Fenster 13 an einer Stelle eingebracht, an der sich die Spulenlagen 9 und 17 gegenüberstehen. Durch Laminieren wird aus den einzelnen Schichten 1a, 1b und 11 ein Verbund hergestellt. Gleichzeitig wird durch den Laminiervorgang erreicht, daß durch das Fenster 13 hindurch eine elektrisch leitende Verbindung zwischen der Spulenlage 9 und der Spulenlage 17 entsteht. Dies kann noch dadurch unterstützt werden, daß auf wenigstens einer der Spulenlagen 9 und 17 gegenüber dem Fenster 13 eine kleine Portion Leitkleber 29 aufgebracht wird, der beim Laminieren in das Fenster 13 fließt und so eine elektrisch leitende Verbindung zwischen den Spulenlagen 9 und 17 herstellt.

In einer Variante der Erfindung können das oder die Fenster 13 in der isolierenden Schicht 11 entfallen. Bei dieser Variante besteht zwischen den einzelnen Spulenlagen keine leitende Verbindung. Die Spulenlagen sind stattdessen kapazitiv gekoppelt. Die kapazitive Kopplung kann auch für die Kopplung des integrierten Schaltkreises 7 an die Spule 3 verwendet werden, so daß hier ebenfalls eine leitende Verbindung entfallen kann.

Ein weiterer Aspekt der Erfindung besteht darin, bisher bestehende Einschränkungen bezüglich der Hochprägbarkeit einer Schaltungseinheit, die eine Spule 3 enthält, aufzuheben. Dies kann durch verschiedene Maßnahmen geschehen, die jeweils sowohl bei einschichtigen als auch bei mehrschichtigen Spulen 3 anwendbar sind.

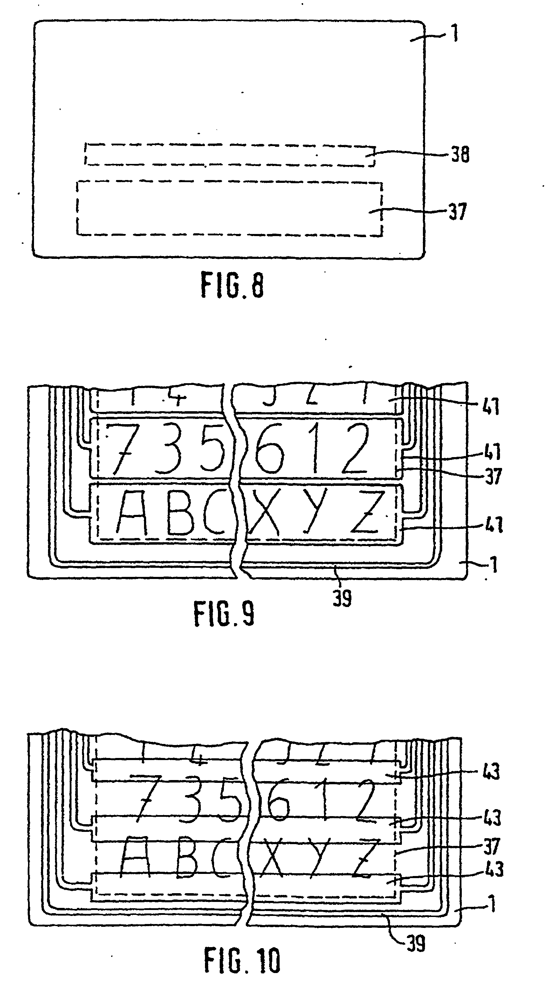

In Fig. 8 ist eine Schaltungseinheit in Aufsicht dargestellt, wobei Bereiche 37 und 38, innerhalb derer gemäß der ISO-Norm 7811 bei Chipkarten Hochprägungen zulässig sind, jeweils durch eine gestrichelte Linie abgegrenzt sind. Mit der Hochprägung können beispielsweise Buchstaben und Zahlen oder andere Zeichen hervorgehoben werden. Die hochgeprägten Zeichen können bei Bedarf mit einer geeigneten Vorrichtung auf einen Papierbeleg abgedruckt werden. Durch das Hochprägen kann es jedoch zu einer Beschädigung der Spule 3 kommen. Besonders problematisch im Hinblick auf eine mögliche Beschädigung von Spulenwindungen ist der untere Bereich 37, da in der Regel eine großflächige Spule 3 benötigt wird, und die Spulenwindungen daher in der Nähe des Randes der Schaltungseinheit verlaufen.

Fig. 9 zeigt einen vergrößerten Ausschnitt der in Fig. 8 dargestellten Schaltungseinheit in Aufsicht. Um eine Unterbrechung der Windungen der Spule 3 zu verhindern, ist in dem Ausführungsbeispiel gemäß Fig. 3 eine Windung 39 zwischen dem Hochprägefeld 37 und dem Rand des Trägersubstrats 1 angeordnet. Falls ausreichend Platz zur Verfügung steht, können hier auch mehrere Windungen oder sogar sämtliche Windungen der Spule 3 verlaufen. Da in diesem Bereich keine Prägung stattfindet, besteht auch nicht die Gefahr, daß die Windungen der Spule 3 durch den Prägevorgang unterbrochen werden. Bei einer mehrschichtigen Spule wird der Platz erst bei höheren Windungszahlen knapp als bei einer einschichtigen Spule, da nicht alle Windungen nebeneinander angeordnet werden müssen.

Im Bereich des Hochprägefelds 37 verlaufen Windungen 41, die in diesem Bereich so stark verbreitert sind, daß sie breiter sind als die Größe der dort eingeprägten Zeichen. Dadurch ist sichergestellt, daß die Windungen 41 durch den Prägevorgang nicht unterbrochen werden, selbst wenn die eingeprägten Zeichen jeweils einen der Zeichengröße entsprechenden Querschnitt der Windungen 41 durchtrennen würden. Falls nicht ausreichend Platz für eine oder mehrere Windungen 39 außerhalb des Hochprägefelds 37 ist, können auch sämtliche Windungen 41 durch das Hochprägefeld 37 geführt werden.

Fig. 10 zeigt ebenfalls einen vergrößerten Ausschnitt der in Fig. 8 dargestellten Schaltungseinheit in Aufsicht. Gemäß dem in Fig. 10 dargestellten Ausführungsbeispiel sind die Windungen der Spule 3 entweder zwischen dem Hochprägefeld 37 und dem Rand der Schaltungseinheit geführt, Windung 39, bzw. im Anschluß an die Hochprägezeilen oder zwischen den einzelnen Hochprägezeilen, Windungen 43. Die Windungen 43, die zwischen den Hochprägezeilen verlaufen bzw. unmittelbar im Anschluß an die Hochprägezeilen, sind dabei etwas verbreitert, um Fertigungstoleranzen auszugleichen. Dadurch ist sichergestellt, daß zumindest ein Teilbereich dieser Windungen 43 auf einer Fläche verläuft, die nicht hochgeprägt wird und somit auch nicht die Gefahr einer Unterbrechung dieser Windungen 43 mit sich bringt. Auch bei dem in Fig. 10 dargestellten Ausführungsbeispiel hängt es von der genauen Abmessung der Windungen ab, ob gar keine oder wenigstens eine Windung 39 am Hochprägefeld vorbeigeführt werden kann, d.h. ob zwischen dem Hochprägefeld 37 und dem Rand des Trägersubstrats ausreichend Platz für eine oder gar für mehrere Windungen 39 ist. Ebenso können die in Fig. 9 und 10 dargestellten Windungsvarianten auch kombiniert werden.

Neben den bereits geschilderten Maßnahmen sind noch weitere denkbar, um eine Unterbrechung der Windungen der Spule 3 durch das Hochprägen zu verhindern. Beispielsweise können die Eigenschaften des zur Herstellung der Windungen verwendeten Beschichtungsmaterials möglichst stark dem Trägersubstrat 1, auf das sie aufgebracht werden, angeglichen werden, damit es beim Hochprägen nicht zu einem Reißen des Beschichtungsmaterials und somit zu einer Unterbrechung der Windungen kommt. Ebenso ist es denkbar, als Beschichtungsmaterial leitfähige Kunststoffe einzusetzen, die so elastisch sind, daß sie beim Hochprägen nicht reißen.

Bei den Ausführungsformen, bei denen eine oder mehrere Windungen 39 zwischen dem Hochprägefeld 37 und dem Rand der Schaltungseinheit geführt werden, kann der Widerstand der Spule 3 unter Umständen unzulässig hohe Werte annehmen, da wegen des geringen Platzangebots die Windungen 39 sehr schmal sein müssen. Diesem Problem kann dadurch gegengesteuert werden, daß man die Windungen 39 in größeren Schichtstärken aufbringt, was beispielsweise durch einen Mehrfachdruck erreicht werden kann. Ebenso ist es auch möglich, zur Reduzierung des Widerstands die Windungen 39 in den Bereichen, in denen ausreichend Platz zur Verfügung steht, zu verbreitern.

Die Herstellung der Schaltungseinheit kann sowohl in Einzelstückfertigung als auch über Bogen oder Bahnen erfolgen, die jeweils am Ende der Fertigung in einzelne Schaltungseinheiten zerteilt werden.

Die beschriebenen Maßnahmen zur Verbesserung der Schaltungseinheit, wie beispielsweise Bereitstellen eines mehrschichtigen Spulenaufbaus, wobei verschiedene Durchkontaktierungsvarianten möglich sind, Ermöglichen der Hochprägung der Schaltungseinheit durch geeignete Wahl der Abmessungen und des Verlaufs, gegebenenfalls auch des Materials der Spulenlagen und direkte Kontaktierung des integrierten Schaltkreises bzw. des Moduls an die Spule, können jeweils sowohl einzeln als auch in Kombination eingesetzt werden.

## Patentansprüche

1. Schaltungseinheit, die mindestens ein isolierendes Trägersubstrat (1), auf dem sich eine leitende, flache Spule (3) befindet, und einen integrierten Schaltkreis (7) umfaßt, dessen Anschlußpunkte (27) direkt oder über Kontakte (25) leitend mit den Spulenenden (15,19) verbunden oder kapazitiv gekoppelt sind, wobei auf dem isolierenden Trägersubstrat (1) im Wechsel Spulenlagen (9, 17) und isolierende Schichten (11) aufgebracht sind, wobei jede isolierende Schicht wenigstens eine Durchbrechung (13) aufweist, durch die die angrenzenden Spulenlagen (9, 17) leitend durch das Spulenmaterial der weiter vom isolierenden Trägersubstrat (1) entfernt liegenden Spulenlage (17) miteinander verbunden sind oder wobei die angrenzenden Spulenlagen (9, 17) kapazitiv gekoppelt sind, so daß aus den einzelnen Spulenlagen (9, 17) eine Spule (3) entsteht.

2. Schaltungseinheit nach Anspruch 1, **dadurch gekennzeichnet, daß** die wenigstens eine Durchbrechung (13) der isolierenden Schicht (11) auf ein Spulenende der Spulenlage (9) führt, die durch die isolierende Schicht (11) abgedeckt wird und daß dieses Ende der Spulenlage (9) mit einem Ende der auf der isolierend Schicht (11) liegenden Spulenlage (17) durch die wenigstens eine Durchbrechung (13) in der isolierenden Schicht (11) leitend verbunden ist.

3. Schaltungseinheit nach Anspruch 1 oder 2, **dadurch gekennzeichnet, daß** die Schaltungseinheit wenigstens ein Hochprägefeld (37) aufweist, in dessen Bereich Zeichen auf der Schaltungseinheit prägbar sind, und daß die Abmessungen und/oder die Anordnung der Spulenwindungen auf dem Trägersubstrat (1) so gewählt sind, daß die Spule (3) beim Prägen der Zeichen nicht vollständig durchtrennt wird.

4. Schaltungseinheit nach Anspruch 3, **dadurch gekennzeichnet, daß** wenigstens eine Spulenwindung (39) zwischen dem Hochprägefeld (37) und dem Rand des Trägersubstrats (1) verläuft.

5. Schaltungseinheit nach einem der Ansprüche 3 bis 4, **dadurch gekennzeichnet, daß** die Spulenwindungen (41) im Bereich des Hochprägefelds (37) breiter sind als die Größe der geprägten Zeichen.

6. Schaltungseinheit nach einem der Ansprüche 3 bis 5, **dadurch gekennzeichnet, daß** die Spulenwindungen (43) zwischen aufeinanderfolgenden Zeilen des Hochprägefelds (37) verlaufen.

7. Schaltungseinheit nach Anspruch 6, **dadurch gekennzeichnet, daß** die Spulenwindungen (43) im Bereich des Hochprägefelds (37) breiter sind als der Abstand der aufeinanderfolgenden Zeilen.

8. Schaltungseinheit nach Anspruch 3, **dadurch gekennzeichnet, daß** die Materialeigenschaften der Spule (3) wenigstens im Bereich des Hochprägefelds (37) dem Trägersubstrat (1) derart angeglichen sind, daß beim Prägen der Zeichen keine die Funktion der Spule (3) in unzulässiger Weise beeinträchtigenden Risse im Spulenmaterial entstehen.

9. Schaltungseinheit nach Anspruch 8, **dadurch gekennzeichnet, daß** die Spule (3) aus einem leitfähigem Kunststoff besteht.

10. Schaltungseinheit nach einem der Ansprüche 1 bis 9, **dadurch gekennzeichnet, daß** die Spule (3) auf das isolierende Trägersubstrat (1) bzw. auf die isolierenden Schichten (11) aufgedruckt ist.

11. Chipkarte, **dadurch gekennzeichnet, daß** sie eine Schaltungseinheit nach einem der Ansprüche 1 bis 10 aufweist.

12. Verfahren zur Herstellung einer Schaltungseinheit mit einem isolierenden Trägersubstrat (1), auf dem sich eine leitende Spule (3) befindet, und mit einem integrierten Schaltkreis (7), dessen Anschlußpunkte (27) direkt oder über Kontakte (25) leitend mit den Spulenenden (15,19) verbunden sind, **gekennzeichnet, durch** folgende Verfahrensschritte:
a) auf das Trägersubstrat (1) wird eine Spulenlage (9) mit mindestens einer Spulenwindung aufgebracht,
b) zumindest der Bereich der aufgebrachten Spulenlage (9) wird mit einer isolierenden Schicht (11) abgedeckt, die wenigstens eine Durchbrechung (13) enthält, **durch** die mindestens eine der abgedeckten Spulenwindungen der Spulenlage (9) zugänglich ist,
c) auf die isolierende Schicht (11) wird eine weitere Spulenlage (17) mit mindestens einer Spulenwindung aufgebracht, die **durch** die wenigstens eine Durchbrechung (13) leitend mit der zuvor abgedeckten Spulenlage (9) verbunden wird, wobei die leitende Verbindung **durch** das Spulenmaterial der weiteren Spulenlage (17) hergestellt wird,
d) gegebenenfalls werden die Verfahrensschritte b) und c) ein- oder mehrfach wiederholt,
e) die Anschlußpunkte (27) des integrierten Schaltkreises (7) bzw. die Kontakte (25) eines Moduls (23), das den integrierten Schaltkreis (7) enthält, werden leitend mit einem Spulenende (15) der Spulenlage (9), die direkt auf dem isolierenden Trägersubstrat (1) liegt, einerseits und mit einem Spulenende (19) der zuletzt aufgebrachten Spulenlage (17) andererseits leitend verbunden.

13. Verfahren nach Anspruch 12, **dadurch gekennzeichnet, daß** die leitende Verbindung der Spulenlagen (9, 17) untereinander durch die wenigstens eine Durchbrechung (13) in der isolierenden Schicht (11) mittels Laminierung der isolierenden Schicht (11) bzw. der isolierenden Schichten (11) und des isolierenden Trägersubstrats (1) erfolgt.

14. Verfahren nach Anspruch 12 oder 13, **dadurch gekennzeichnet,**
- **daß** auf das Trägersubstrat (1) die Spule (3) so aufgebracht wird, daß die Entfernung zwischen den Spulenenden (15, 19) durch die Anschlußpunkte (27) des integrierten Schaltkreises (7) bzw. durch die Kontakte (25) eines Moduls (23), das den integrierten Schaltkreis (7) enthält, überbrückt werden kann und
- **daß** der integrierte Schaltkreis (7) bzw. das Modul (23) so auf die Spulenenden (15, 19) aufgesetzt wird, daß sich die Anschlußpunkte (27) des integrierten Schaltkreises (7) und die Spulenenden (15,19) bzw. die Kontakte (25) des Moduls (23) und die Spulenenden (15,19) berühren und
- **daß** ein elektrischer Kontakt zwischen den Anschlußpunkten (27) und den Spulenenden (15, 19) bzw. den Kontakten (25) und den Spulenenden (15, 19) allein durch diese Berührung entsteht.

15. Verfahren nach Anspruch 14, **dadurch gekennzeichnet, daß** die Spule (3) auf das Trägersubstrat (1) aufgedruckt wird und der integrierte Schaltkreis (7) bzw. das Modul (23) vor dem vollständigen Trocknen des Druckmaterials aufgesetzt wird.

16. Verfahren nach Anspruch 12 oder 13, **dadurch gekennzeichnet,**
- **daß** der integrierte Schaltkreis (7) bzw. ein Modul (23), das den integrierten Schaltkreis (7) enthält, so in das Trägersubstrat (1) eingebracht wird, daß die Anschlußpunkte (27) des integrierten Schaltkreises (3) bzw. die Kontakte (25) des Moduls mit der Oberfläche des Trägersubstrats (1) abschließen,
- **daß** anschließend die Spule (3) so auf das Trägersubstrat (1) aufgebracht wird, daß die Spulenenden (15,19) die Anschlußpunkte (27) bzw. die Kontakte (25) wenigstens teilweise überdecken
- und **daß** ein elektrischer Kontakt zwischen den Anschlußpunkten (27) und den Spulenenden (15, 19) bzw.den Kontakten (25) und den Spulenenden (15,19) allein durch die direkte Berührung zustandekommt.

17. Verfahren nach Anspruch 16, **dadurch gekennzeichnet, daß** die Spule (3) aufgedruckt wird.

18. Chipkarte, **dadurch gekennzeichnet, daß** sie eine nach einem der Ansprüche 12 bis 17 herstellbare Schaltungseinheit aufweist.

## Claims

1. A circuit unit comprising at least an insulating carrier substrate (1) on which a conductive, flat coil (3) is located, and an integrated circuit (7) whose connection points (27) are electrically connected with the coil ends (15, 19) directly or via contacts (25) or coupled capacitively therewith, whereby coil layers (9, 17) and insulating layers (11) are applied alternately to the insulating substrate (1), each insulating layer having at least one opening (13) through which the adjacent coil layers (9, 17) are electrically interconnected by the coil material of the coil layer (17) more remote from the insulating carrier substrate (1), or the adjacent coil layers (9, 17) being coupled capacitively, so that the individual coil layers (9, 17) yield a coil (3).

2. The circuit unit of claim 1, **characterized in that** the at least one opening (13) in the insulating layer (11) leads to one end of the coil layer (9) covered by the insulating layer (11), and this end of the coil layer (9) is electrically connected with one end of the coil layer (17) located on the insulating layer (11) through the at least one opening (13) in the insulating layer (11).

3. The circuit unit of claim 1 or 2, **characterized in that** the circuit unit has at least one relief embossing field (37) in the area of which characters are embossable on the circuit unit, and the dimensions and/or the arrangement of turns of the coil on the substrate (1) are selected so that the coil (3) is not completely severed during embossing of the characters.

4. The circuit unit of claim 3, **characterized in that** at least one turn (39) of the coil runs between the relief embossing field (37) and the edge of the substrate (1).

5. The circuit unit of any of claims 3 to 4, **characterized in that** the turns (41) of the coil are wider in the area of the relief embossing field (37) than the size of the embossed characters.

6. The circuit unit of any of claims 3 to 5, **characterized in that** the turns (43) of the coil run between successive lines of the relief embossing field (37).

7. The circuit unit of claim 6, **characterized in that** the turns (43) of the coil are wider in the area of the relief embossing field (37) than the distance between successive lines.

8. The circuit unit of claim 3, **characterized in that** the material properties of the coil (3) are adapted to the substrate (1) at least in the area of the relief embossing field (37) in such a way that no cracks inadmissibly impairing the function of the coil (3) arise in the coil material during embossing of the characters.

9. The circuit unit of claim 8, **characterized in that** the coil (3) consists of conductive plastic.

10. The circuit unit of any of claims 1 to 9, **characterized in that** the coil (3) is printed on the insulating substrate (1) or on the insulating layers (11).

11. A chip card, **characterized in that** it has the circuit unit of any of claims 1 to 10.

12. A method for producing a circuit unit comprising an insulating carrier substrate (1) on which a conductive coil (3)-is located, and an integrated circuit (7) whose connection points (27) are electrically connected with the coil ends (15, 19) directly or via contacts (25), **characterized by** the following method steps:
a) applying a coil layer (9) with at least one turn to the substrate (1),
b) covering at least the area of the applied coil layer (9) with an insulating layer (11) containing at least one opening (13) through which at least one of the covered turns of the coil layer (9) is accessible,
c) applying to the insulating layer (11) a further coil layer (17) with at least one turn which is electrically connected with the previously covered coil layer (9) through the at least one opening (13), the electric connection being produced by the coil material of the further coil layer (17),
d) optionally repeating method steps b) and c) once or several times,
e) electrically connecting the connection points (27) of the integrated circuit (7), or the contacts (25) of a module (23) containing the integrated circuit (7), with one end (15) of the coil layer (9) located directly on the insulating substrate (1), on the one hand, and with one end (19) of the last applied coil layer (17), on the other hand.

13. The method of claim 12, **characterized in that** the electric connection between the coil layers (9, 17) takes place through the at least one opening (13) in the insulating layer (11) by laminating the insulating layer (11) or insulating layers (11) and the insulating substrate (1).

14. The method of claim 12 or 13, **characterized by** the steps of:
applying the coil (3) to the substrate (1) in such a way that the distance between the coil ends (15, 19) can be bridged by the connection points (27) of the integrated circuit (7) or by the contacts (25) of a module (23) containing the integrated circuit (7), and
mounting the integrated circuit (7) or the module (23) on the coil ends (15, 19) in such a way that the connection points (27) of the integrated circuit (7) and the coil ends (15, 19) or the contacts (25) of the module (23) and the coil ends (15, 19) touch, and
forming an electric contact between the connection points (27) and the coil ends (15, 19) or the contacts (25) and the coil ends (15, 19) solely through this touching.

15. The method of claim 14, **characterized in that** the coil (3) is printed on the substrate (1), and the integrated circuit (7) or the module (23) is mounted before the printing material completely dries.

16. The method of claim 12 or 13, **characterized by** the steps of:
incorporating the integrated circuit (7) or a module (23) containing the integrated circuit (7) in the substrate (1) in such a way that the connection points (27) of the integrated circuit (3) or the contacts (25) of the module are flush with the surface of the substrate (1),
then applying the coil (3) to the substrate (1) in such a way that the coil ends (15, 19) at least partly cover the connection points (27) or the contacts (25), and
forming an electric contact between the connection points (27) and the coil ends (15, 19) or the contacts (25) and the coil ends (15, 19) solely through this direct touching.

17. The method of claim 16, **characterized in that** the coil (3) is printed on.

18. A chip card, **characterized in that** it has a circuit unit producible according to any of claims 12 to 17.

## Revendications

1. Unité de circuit comprenant au moins un substrat porteur isolant (1) sur lequel se trouve une bobine plate conductrice (3) et un circuit intégré (7) dont les points de raccordement (27) sont reliés ou couplés de manière capacitive directement ou par l'intermédiaire de contacts (25) avec les extrémités de la bobine (15, 19), des couches d'enroulements (9, 17) et des couches isolantes (11) étant alternées sur le substrat porteur (1), chaque couche isolante comportant au moins un perçage (13) à travers lequel les couches d'enroulement (9, 17) adjacentes sont reliées entre elles de manière conductrice par l'intermédiaire du matériau d'enroulement de la couche d'enroulement (17) située plus loin sur le substrat porteur isolant (1) ou les couches d'enroulement (9, 17) adjacentes étant couplées de manière capacitive, de telle sorte qu'une bobine (3) soit formée à partir des différentes couches d'enroulement (9, 17).

2. Unité de circuit selon la revendication 1, **caractérisée en ce que** le perçage (13) de la couche isolante (11) conduit à une extrémité d'enroulement de la couche d'enroulement (9), qui est recouverte par la couche isolante (11) et **en ce que** cette extrémité de la couche d'enroulement (9) est reliée de manière conductrice avec une extrémité de la couche d'enroulement (17) située sur la couche isolante (11) par l'intermédiaire d'au moins un perçage (13) dans la couche isolante (11).

3. Unité de circuit selon la revendication 1 ou 2, **caractérisée en ce que** l'unité de circuit comporte au moins un champ d'estampage (37) au niveau duquel des symboles peuvent être estampés sur l'unité de circuit et **en ce que** les dimensions et/ou la disposition des enroulements de la bobine sur le substrat porteur (1) sont sélectionnées de telle sorte que la bobine (3) n'est pas complètement sectionnée lors de l'estampage des symboles.

4. Unité de circuit selon la revendication 3, **caractérisée en ce qu'**au moins un enroulement de bobine (39) est situé entre le champ d'estampage (37) et le bord du substrat porteur (1).

5. Unité de circuit selon l'une des revendications 3 à 4, **caractérisée en ce que** les enroulements de la bobine (41) au niveau du champ d'estampage (37) sont plus larges que la taille des symboles estampés.

6. Unité de circuit selon l'une des revendications 3 à 5, **caractérisée en ce que** les enroulements de la bobine (43) sont situés entre des lignes successives du champ d'estampage (37).

7. Unité de circuit selon la revendication 6, **caractérisée en ce que** les enroulements de la bobine (43) au niveau du champ d'estampage (37) sont plus larges que la distance entre des lignes successives.

8. Unité de circuit selon la revendication 3, **caractérisée en ce que** les propriétés du matériau de la bobine (3), au moins au niveau du champ d'estampage (37), sont harmonisées avec celles du substrat porteur (1) de telle sorte que, lors de l'estampage des symboles, ne survienne aucune fissure dans le matériau de la bobine provoquant un endommagement inadmissible du fonctionnement de la bobine (3).

9. Unité de circuit selon la revendication 8, **caractérisée en ce que** la bobine (3) est constituée d'une matière plastique conductrice.

10. Unité de circuit selon l'une des revendications 1 à 9, **caractérisée en ce que** la bobine (3) est imprimée sur le substrat porteur isolant (1) ou sur les couches isolantes (11).

11. Carte à puce, **caractérisée en ce qu'**elle comporte une unité de circuit selon l'une des revendications 1 à 10.

12. Procédé de fabrication d'une unité de circuit avec un substrat porteur isolant (1) sur lequel se trouve une bobine conductrice (3) et avec un circuit intégré (7) dont les points de connexion (27) sont reliés avec les extrémités de la bobine (15, 19) directement ou par l'intermédiaire de contacts (25), **caractérisé par** les étapes de procédé suivantes :
a) une couche d'enroulements (9) avec au moins un enroulement de bobine est appliquée sur le substrat porteur (1),
b) au moins la zone de la couche de bobine appliquée (9) est recouverte avec la couche isolante (11) qui contient au moins un perçage (13) à travers lequel au moins des enroulements de bobine de la couche d'enroulements (9) peut être accessible,
c) sur la couche isolante (11), est appliquée une couche d'enroulement supplémentaire (17), avec au moins un enroulement de bobine, qui est reliée de manière conductrice, par l'intermédiaire d'au moins un perçage (13), avec la couche d'enroulement (9), la liaison conductrice étant réalisée par le matériau de la couche d'enroulement (17) suivante,
d) le cas échéant, les étapes du procédé b) et c) sont répétées une ou plusieurs fois,
e) les points de connexion (27) du circuit intégré (7) ou les contacts (25) d'un module (23) comprenant le circuit intégré (7) sont reliés de manière conductrice d'une part avec une extrémité de bobine (15) de la couche d'enroulement (9) qui se trouve directement sur le substrat porteur isolant (1), et d'autre part avec une extrémité de bobine (19) de la couche d'enroulement (17) appliquée en dernier.

13. Procédé selon la revendication 12, **caractérisé en ce que** la liaison conductrice des couches d'enroulements (9, 17) entre elles à travers le perçage (13) est réalisée grâce au contrecollage de la couche isolante (11) ou des couches isolantes (11) et du substrat porteur isolant (1).

14. Procédé selon la revendication 12 ou 13, **caractérisé en ce que**
- sur le substrat porteur (1), la bobine (3) est appliquée de telle sorte que la distance entre les extrémités de la bobine (15, 19) puisse être pontée par les points de connexion (27) du circuit intégré (7) ou par les contacts (25) d'un module (23) comprenant le circuit intégré (7) et
- le circuit intégré (7) resp. le module (23) est disposé sur les extrémités de la bobine (15, 19) de telle sorte que les points de connexion (27) du circuit intégré (7) et les extrémités de la bobine (15, 19) resp. les contacts (25) du module (23) ou les extrémités de la bobine (15, 19) se touchent et
- un contact électrique est réalisé entre les points de connexion (27) et les extrémités de la bobine (15, 19) ou entre les contacts (25) et les extrémités de la bobine (15, 19) uniquement grâce à ce contact.

15. Procédé selon la revendication 14, **caractérisé en ce que** la bobine (3) est imprimée sur le substrat porteur (1) et le circuit intégré (7) ou le module (23) est posé avant le séchage complet du matériau d'impression.

16. Procédé selon la revendication 12 ou 13, **caractérisée en ce que**
- le circuit intégré (7) resp. un module (23) comprenant le circuit intégré (7) est inséré dans le substrat porteur (1) de telle sorte que les points de connexion (27) du circuit intégré (3) resp, les contacts (25) du module soient en contact avec la surface du substrat porteur (1),
- la bobine (3) est ensuite appliquée sur le substrat porteur (1) de telle sorte que les extrémités de la bobine (15, 19) recouvrent au moins partiellement les points de connexion (27) ou les contacts (25)
- un contact électrique entre les points de connexion (27) et les extrémités de la bobine (15, 19) ou entre les contacts (25) et les extrémités de la bobine (15, 19) est réalisé est réalisé est réalisé uniquement grâce à ce contact direct.

17. Procédé selon la revendication 16, **caractérisé en ce que** la bobine (3) est imprimée.

18. Carte à puce, **caractérisée en ce qu'**elle comporte une unité de circuit pouvant être fabriquée selon l'une des revendications 12 à 17.
